# FASCICULE DE BREVET EUROPEEN

(11) **EP 0 752 743 B1**
(45) Date de publication et mention de la délivrance du brevet: **06.06.2001**
(21) Numéro de dépôt: 96401494.8
(22) Date de dépôt: 05.07.1996
(51) Int. Cl.: H01S 5/10, H01S 5/32, H01S 5/40, H01S 5/02

(54) **Dispositif laser à structure enterrée pour circuit photonique intégré et procédé de fabrication**
Laservorrichtung mit vergrabener Struktur für integrierte photonische Schaltung und Herstellungsverfahren
Laser device with buried structure for integrated photonic circuit and method of fabrication

(30) Priorité: 06.07.1995 FR 9508200
(43) Date de publication de la demande: 08.01.1997
(73) Titulaire: FRANCE TELECOM, 75015 Paris (FR)
(72) Inventeur: Mersali, Boumédienne, Cabinet Ballot-Schmit, 94230 Cachan (FR); Dorgeuille,Francois, Cabinet Ballot-Schmit, 94230 Cachan (FR)
(74) Mandataire: Schmit, Christian Norbert Marie

(56) Documents cités:
- EP-A- 0 378 447
- EP-A- 0 402 907
- EP-A- 0 434 528
- ELECTRONICS LETTERS, vol. 30, no. 16, 4 Août 1994, STEVENAGE, GB, pages 1290-1291, XP000468793 H.J.BRÜCKNER ET AL.: "Taper-waveguide integration for polarisation insensitive InP/InGaAsP based optical amplifiers"
- APPLIED PHYSICS LETTERS, vol. 54, no. 2, 9 Janvier 1989, NEW YORK, US, pages 114-116, XP000025821 K.-Y. LIOU ET AL.: "Monolithic integrated InGaAsP/InP distributed feedback laser with Y-branching waveguide and a monitoring photodetector grown by metalorganic chemical vapor deposition"
- ELECTRONICS LETTERS, vol. 31, no. 7, 30 Mars 1995, STEVENAGE, GB, pages 559-560, XP000504312 A.KASUKAWA ET AL.: "Output beam characteristics of 1.3um GaInAsP/InP SL-QW lasers with narrow and circular output beam"
- APPLIED PHYSICS LETTERS, vol. 59, no. 1, 1 Juillet 1991, NEW YORK, US, pages 22-24, XP000234389 N.BOUADMA ET AL.: "Over 245mW 1.3um buried ridge stripe laser diodes on n-substrate fabricated by the reactive ion beam etching technique"

## Description

L'invention se rapporte à un dispositif laser, ou amplificateur à guide optique, enterré à double hétérostructure, et à un procédé simple d'intégration monolithique de ce dispositif dans des circuits photoniques complexes.

Un tel dispositif est très utile notamment -pour la réalisation de circuits optiques intégrés complexes employés dans le domaine de l'optique intégrée ou des télécommunications optiques par exemple.

Jusqu'à présent, beaucoup de solutions différentes ont déjà été envisagées pour réaliser des dispositifs laser, ou amplificateurs optiques, à structure enterrée, intégrés dans des circuits photoniques. Dans tous les cas, les procédés de fabrication sont complexes et nécessitent plusieurs épitaxies, c'est-à-dire au moins trois épitaxies, et/ou des épitaxies spécifiques telles que des épitaxies localisées par exemple.

De plus, bien que les performances des composants actifs, c'est-à-dire des lasers ou des amplificateurs réalisés selon les procédés existants, soient généralement bonnes ; celles des guides optiques sont souvent insuffisantes, si bien qu'elles imposent une limitation de la taille des circuits optiques intégrés. Enfin, la qualité du couplage entre deux fonctions optiques varie énormément selon les procédés utilisés.

Une publication récente intitulée "Taper-waveguide integration for polarisation insensitive InP/InGaAsP based optical amplifiers", Electronics Letters 04/08/1994 Vol.30 N°16, décrit une technique simple d'intégration d'un amplificateur avec un guide optique conçu pour faciliter le couplage avec une fibre optique.

Cependant, ce dispositif possède une couche guidante d'épaisseur extrêmement fine, de l'ordre de 0,04 micromètres (mm), permettant d'obtenir un très faible facteur de confinement. Le dispositif présente donc un mode déconfiné permettant de le coupler à une fibre optique. De plus, le guide optique présente de fortes pertes optiques dues à l'absorption de porteurs libres de type p qui constituent des éléments de dopage des couches d'InP. Néanmoins, pour réaliser des circuits photoniques intégrés, il est nécessaire de réaliser des dispositifs possédant un mode très confiné et de faibles pertes optiques. Pour cette raison, le dispositif décrit dans ce document ne peut être valablement adapté à la réalisation de circuits photoniques.

La demande de brevet européen EP-A-0378 447 décrit un laser à semi-conducteur présentant une couche intermédiaire de séparation comprise entre 0,01 et 0,1 µm dopée en porteurs du premier type.

Selon ce document, cette couche de séparation permet essentiellement de réaliser une bonne transition entre les couches active et guidante du dispositif lors de l'épitaxie et de faciliter les gravures éventuelles en jouant le rôle d'une couche d'arrêt.

Il n'est cependant nullement précisé ni suggéré que cette couche intermédiaire est dopée à une forte concentration afin d'obtenir des homojonctions latérales bloquantes et une lumière très confinée.

Tous les procédés existant actuellement, faisant appel à une technologie simple, ne permettent donc pas de réaliser des dispositifs possédant simultanément de bonnes performances pour deux fonctions optiques différentes : il y a toujours un compromis à faire entre les performances des deux fonctions optiques intégrées, au détriment de la qualité des guides. Il existe cependant d'autres procédés, permettant de réaliser des dispositifs possédant de bonnes performances pour deux fonctions optiques différentes ; mais ces procédés font appel à des technologies très complexes, mettant en oeuvre trois à cinq épitaxies, si bien qu'il est très difficile d'obtenir les dispositifs souhaités. En conséquence, les dispositifs fabriqués jusqu'à présent ne permettent pas de réaliser, de manière simple, des circuits photoniques intégrés complexes comportant des éléments tels que des virages, des croisements ou des branchements en Y par exemple.

Un premier objet de la présente invention concerne un dispositif laser, ou amplificateur à guide optique, enterré et à double hétérostructure, caractérisé en ce qu'il comprend
- une couche tampon dopée en porteurs d'un premier type et recouvrant toute la surface d'un substrat dopé en porteurs du même type,
- une première couche guidante, jouant le rôle de guide optique, formée d'un composé quaternaire non dopé et recouvrant toute la surface de la couche tampon,
- une couche intermédiaire d'une épaisseur comprise entre 0,01 µm et 0,1 µm, dopée en porteurs du premier type à une concentration comprise entre 2.10¹⁷ et 2.10¹⁸ cm⁻³, et recouvrant au moins une partie de la surface de la couche guidante,
- un ou plusieurs ruban(s) de couche active, jouant le rôle de laser(s) ou d'amplificateur(s) formé(s) d'un composé quaternaire non dopé, et
- une couche de gaine dopée en porteurs d'un deuxième type.

Ce dispositif laser enterré à double hétérostructure, appelé aussi, en dénomination anglo-saxonne, "Double Buried Heterostructure" (DBH), possède une structure du même type que celle du dispositif laser classique à ruban enterré, appelé aussi, en dénomination anglo-saxonne, "Buried Ridge Stripe" (BRS).

La couche intermédiaire, d'épaisseur extrêmement fine et fortement dopée, permet notamment d'obtenir un fort coefficient de couplage entre deux fonctions optiques et d'obtenir de bonnes jonctions latérales P-N bloquantes qui sont nécessaires et suffisantes pour injecter du courant dans le dispositif laser. Cette couche intermédiaire permet en outre de protéger la couche guidante contre la diffusion de porteurs libres de type p, lors d'une reprise d'épitaxie d'une couche de gaine afin d'enterrer le ruban de couche active.

Un autre objet de la présente invention concerne un procédé de fabrication d'un tel dispositif à structure enterrée et d'intégration de ce-dernier, avec un guide optique, dans un circuit photonique. Ce procédé est caractérisé en ce qu'il consiste à faire croître successivement, sur une couche tampon dopée en porteurs d'un premier type, elle-même déposée sur toute une surface (100) d'un substrat dopé en porteurs du même type, une première couche guidante formée d'un composé quaternaire non dopé, une couche intermédiaire d'une épaisseur comprise entre 0,01 µm et 0,1 µm et fortement dopée en porteurs du premier type à une concentration comprise entre 2.10¹⁷ et 2.10¹⁸ cm⁻³, une deuxième couche, dite couche active, formée d'un composé quaternaire non dopé, et une couche de protection dopée en porteurs d'un deuxième type; et en ce que la couche active est gravée sous la forme d'un ou de plusieurs rubans puis enterrée dans une couche de gaine dopée en porteurs du deuxième type.

Le fait de graver uniquement la couche active permet d'obtenir, sous cette-dernière, une couche guidante épaisse présentant par conséquent 'un fort facteur de confinement. Un guide simple hétérostructure, par exemple, dont le coeur est constitué d'un matériau quaternaire d'InGaAsP, de largeur de bande interdite égale, en longueur d'onde, à 1.3 *µ*m, doit avoir une épaisseur nécessairement supérieure à 0.3 *µ*m, afin d'assurer la propagation de la lumière.

Le fait d'introduire une couche intermédiaire entre les deux couches possédant des fonctions optiques différentes et le fait de ne graver que la couche active, permet d'utiliser des couches épaisses pour chacune des fonctions optiques et, par conséquent, d'obtenir simultanément de bonnes performances pour les deux fonctions optiques. De ce fait, le dispositif laser selon l'invention peut valablement s'appliquer à la réalisation de circuits optiques intégrés complexes.

D'autres particularités et avantages de l'invention apparaîtront à la lecture de la description faite à titre d'exemple illustratif et non limitatif en référence aux figures annexées qui représentent :
- la figure 1, un schéma d'un dispositif selon l'invention,
- les figures 2A à 2G, une vue en coupe du dispositif de la figure 1 au cours des différentes étapes d'un procédé de fabrication selon l'invention,
- la figure 3, une vue de l'intérieur d'un autre dispositif selon l'invention,
- la figure 4, une vue de l'intérieur d'un autre dispositif selon une variante de réalisation,
- les figures 5A à 5D, différentes étapes de la fabrication d'un circuit photonique intégré à partir du dispositif de la figure 3,
- la figure 6, un schéma en perspective d'un autre dispositif réalisé selon un procédé de fabrication de l'invention.

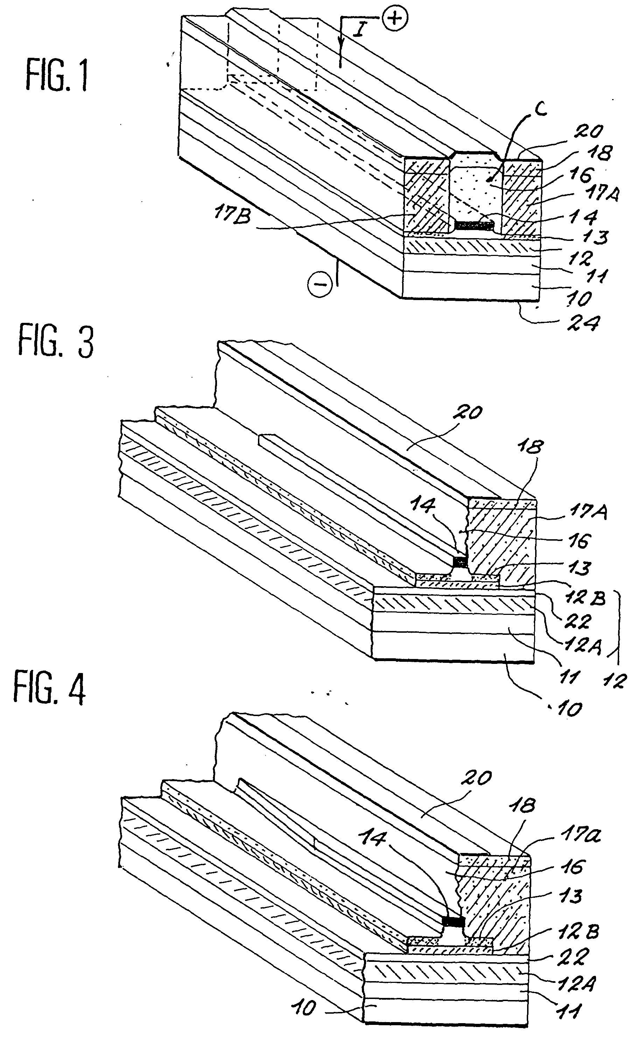

Un mode de réalisation d'un dispositif selon l'invention sera mieux compris au regard de la figure 1 qui représente une vue schématique de sa structure.

Ce dispositif comprend une première couche dite couche guidante 12 et une deuxième couche, dite couche active 14, possédant une fonction optique différente de la première couche puisqu'elle joue le rôle d'amplificateur. Ces deux couches, qui possèdent deux fonctions optiques différentes, sont toutes deux formées d'un composé quaternaire non dopé et sont séparées par une couche intermédiaire 13 extrêmement fine et fortement dopée en porteurs de type n.

De plus, la couche active 14 est gravée sous la forme d'un ou de plusieurs rubans et elle est enterrée dans une couche de gaine 16 dopée en porteurs de type p. Cette couche de gaine est recouverte d'une couche conductrice 18 dopée en porteurs de type p. Enfin, des contacts 20 sont réalisés par métallisation, selon un procédé bien connu de l'homme de l'art.

Selon une variante de réalisation, illustrée sur la figure 1, d'autres contacts 24 sont réalisés sur la face inférieure du dispositif, afin de pouvoir appliquer une tension de fonctionnement aux bornes 20, 24 du dispositif.

Le dispositif est réalisé par épitaxie en phase vapeur en seulement deux étapes. Les couches sont successivement déposées sur une couche tampon 11, dopée en porteurs de type n, elle-même déposée sur un substrat 10 dopé n. Les couches guidante 12 et active 14 sont empilées en une seule épitaxie et une reprise d'épitaxie permet d'enterrer la couche active 14 dans la couche de gaine 16. Ce procédé de fabrication est décrit plus en détails dans ce qui suit.

La couche intermédiaire 13 possède plusieurs fonctions qui contribuent toutes au bon fonctionnement du dispositif. Une première fonction permet l'obtention de jonctions latérales P-N bloquantes qui sont nécessaires et suffisantes pour injecter le courant dans le ruban de couche amplificatrice 14.

Ces jonctions latérales bloquantes sont des jonctions de type P-N et sont formées à l'interface entre la reprise d'épitaxie de la couche de gaine 16 et la très fine couche intermédiaire 13 ou alors sous cette interface. La couche de gaine et la couche intermédiaire sont de préférence réalisées en Phosphure d'Indium (InP).

D'autres jonctions, dénommées jonctions passantes, de type P-I-N, sont formées entre la couche de gaine 16 d'InP dopée p, la couche active 14 non dopée, et la couche intermédiaire 13 dopée n. Par conséquent, le courant I est confiné dans le ou les ruban(s) de la couche active 14 à l'aide d'homojonctions latérales bloquantes P-N contenues dans l'hétérostructure.

Une deuxième fonction de la couche intermédiaire 13 permet d'assurer une protection de la couche guidante 12 contre une diffusion éventuelle de zinc qui est un élément de dopage de la couche de gaine 16. Cette protection contre la diffusion de zinc évite ainsi la formation de pertes optiques dues à l'absorption de porteurs libres dans la couche guidante 12.

De plus, la couche intermédiaire 13 joue un grand rôle dans le fonctionnement du dispositif. Son épaisseur et son dopage doivent être optimisés pour obtenir un bon couplage entre le guide et la fonction active, de bonnes jonctions bloquantes, et de très faibles pertes optiques.

L'épaisseur doit donc être la plus faible possible, pour assurer un bon couplage entre deux fonctions optiques différentes. En revanche, elle doit être la plus grande possible pour avoir des jonctions bloquantes P-N de qualité. Il y a donc un compromis sur l'épaisseur de la couche intermédiaire. De plus, la valeur minimale de l'épaisseur est également limitée par la technologie utilisée pour fabriquer le dispositif. L'épaisseur est par conséquent comprise entre 0.01 et 0.1 *µ*m, et de préférence entre 0,01 et 0,05 *µ*m.

Le dopage doit être maximum pour favoriser la bonne qualité des jonctions bloquantes P-N et limiter la diffusion de Zinc dans la couche guidante 12. Par conséquent, la concentration en porteurs de type n, dans cette couche, est de préférence comprise entre 2.10¹⁷ et 2.10¹⁸ cm⁻³. Le couplage entre le guide et la fonction active est alors évanescent et vertical. De manière avantageuse, ce couplage peut-être amélioré par l'utilisation d'une transition adiabatique, ou encore dénommée adaptateur de modes, entre les deux fonctions optiques.

Le matériau choisit pour réaliser cette couche intermédiaire est de préférence un matériau binaire, tel que l'InP par exemple, qui possède une structure cristalline semblable à celle de la couche active 14 ou de la couche guidante 12.

De plus, une telle couche en matériau binaire d'InP facilite nettement la reprise d'épitaxie de la couche de gaine 16, par rapport à une couche qui serait par exemple réalisée en matériau quaternaire.

De manière avantageuse, la couche guidante 12 est épaisse et permet de réaliser un guide optique de type simple hétérostructure, à faibles pertes optiques, c'est-à-dire à fort facteur de confinement, donc parfaitement adapté à la réalisation des circuits photoniques intégrés. Ce guide est obtenu simplement, à partir de la structure active enterrée comportant un ruban délimité de couche active 14, en gravant une partie de la couche guidante. Ceci est expliqué plus en détails dans ce qui suit.

De plus, cette couche guidante 12, est de préférence formée par un composé quaternaire non dopé, tel que GaₓIn₁₋ₓAs_{y}P_{1-y} par exemple, avec x et y pouvant varier de 0 à 1. La composition de cette couche est avantageusement choisie de manière à ce que la largeur de bande interdite soit égale, en longueur d'onde, à 1,3*µ*m et transparente aux longueurs d'onde d'utilisation qui sont comprises entre 1.45 et 1.75 *µ*m.

De manière avantageuse, la couche guidante 12, située sous la couche active 14, n'est pas gravée. Seule la couche active, d'épaisseur inférieure à 0.6*µ*m, est gravée sous la forme d'un ou de plusieurs rubans, de manière à améliorer la directivité de l'émission laser et à diminuer le courant de seuil de fonctionnement du dispositif laser. Dans l'exemple de la figure 1, un seul ruban de couche active 14 est gravé. Pour cette raison la gravure, dont la profondeur n'excède pas 0.6*µ*m, n'impose plus une limitation de la somme des épaisseurs des couches guidante et active, mais seulement une limitation de l'épaisseur de la couche active 14 qui n'excède pas 0.6*µ*m. Par conséquent la couche guidante 12, située sous la couche active 14, peut posséder une épaisseur relativement importante sans que le fonctionnement du laser soit perturbé. Ainsi, dans l'exemple du guide simple hétérostructure précédemment cité, l'épaisseur de la couche guidante est avantageusement comprise entre 0,3*µ*m et 1*µ* m. De manière générale, l'épaisseur de la couche guidante est inférieure à 1*µ*m, quel que soit le guide réalisé. De plus, du fait de l'importance de l'épaisseur de cette couche, le facteur de confinement est élevé.

En outre, la couche active 14 est de préférence formée d'un composé quaternaire non dopé, tel que GaₓIn₁₋ₓAs_{y}P_{1-y} par exemple, avec x et y compris entre 0 et 1. La composition de cette couche est avantageusement choisie de manière à ce qu'elle émette à une longueur d'onde d'utilisation λg comprise entre 1.45 *µ*m et 1.75 *µ*m. D'autre part, la couche active 14 peut aussi bien être réalisée à partir d'un matériau massif, encore dénommé matériau "bulk" en littérature anglo-saxonne, qu'à base de puits quantiques.

La couche conductrice 18 dopée en porteurs de type p et recouvrant la couche de gaine 16 est avantageusement réalisée en matériau ternaire d'InGaAs.

Les régions latérales 17A et 17B des couches conductrice 18, de gaine 16 et intermédiaire 13 sont de préférence implantées en protons.

En effet, l'implantation de protons dans ces deux régions 17A et 17B permet de détruire partiellement la structure cristalline de ces couches 18, 16, 13, afin d'augmenter fortement leur résistivité et de réduire ainsi la section d'un canal C dans lequel circule le courant I. Par conséquent, cette implantation de protons permet d'augmenter le confinement du courant dans la couche active 14.

Le dispositif qui vient d'être décrit comporte deux couches possédant des fonctions optiques différentes. Ceci n'est qu'un exemple et il est tout à fait possible, dans une variante de réalisation, d'obtenir un dispositif à plus de deux fonctions optiques distinctes, comme par exemple un dispositif optiques dans lequel sont intégrés un amplificateur, une photodiode, un guide optique et un modulateur.

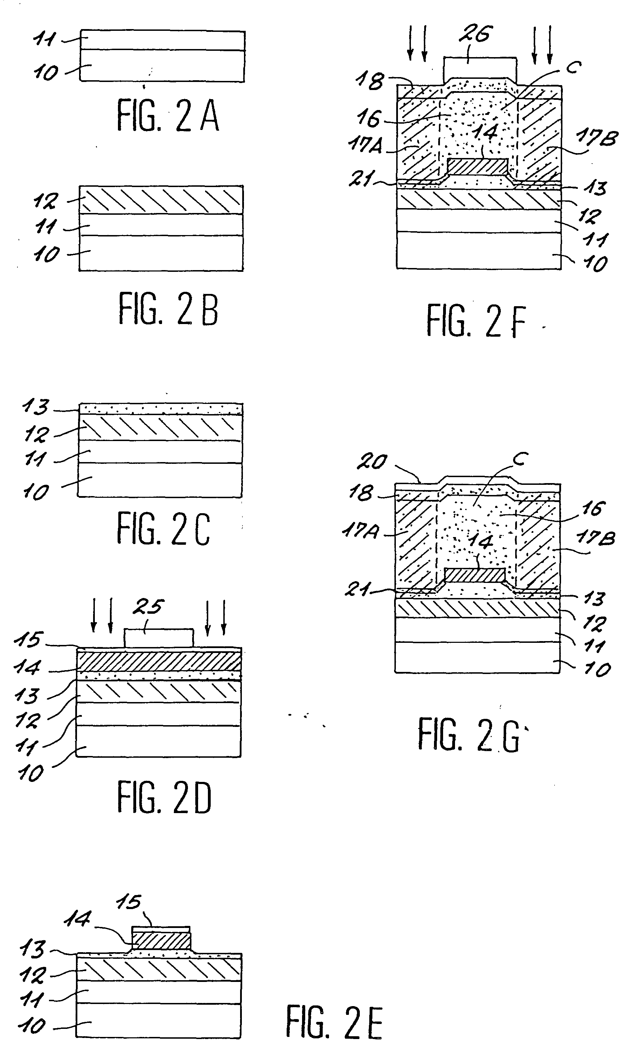

Un exemple de réalisation d'un procédé de fabrication d'un tel dispositif est illustré sur les figures 2A à 2G. Dans un premier temps, un substrat plat 10 tel que représenté sur la figure 2A, est prévu. Ce substrat est de préférence réalisé en Phosphure d'Indium dopé en porteurs de type n. Une couche tampon 11, également dopée en porteurs de type n, est déposée par épitaxie en phase gazeuse sur toute la surface (100) du substrat. Cette couche tampon 11 est également réalisée en Phosphure d'Indium, elle permet de faciliter la croissance des autres couches réalisées par épitaxie car elle présente très peu de défauts. Cette couche tampon 11 n'est pas indispensable. Cependant elle peut devenir nécessaire, lorsque le substrat présente de nombreux défauts, afin de rétablir l'homogénéité du matériau d'InP dopé en porteurs n.

Plusieurs couches successives sont ensuite déposées, en une seule étape, sur la couche tampon 11 à l'aide d'une technique bien connue d'épitaxie en phase vapeur, que l'on retrouve souvent écrite sous l'abréviation anglo-saxonne CVD (chemical Vapour Deposition). L'épaisseur de la couche tampon est avantageusement comprise entre 0,5 et 0,7 *µ*m. En effet au-dessous de 0,5 *µ*m l'épaisseur est trop fine si bien que la couche tampon n'est pas de très bonne qualité. En revanche, lorsque l'épaisseur devient supérieure à 0,7 *µ*m, la bonne qualité de cette couche est maximum et ne peut plus être améliorée. Dans l'exemple de la figure 2, l'épaisseur de la couche tampon 11 est de préférence égale à 0,6 *µ*m.

Une première couche 12, d'un composé quaternaire non dopé, est ensuite déposée sur la couche tampon, tel qu'illustré sur la figure 2B. Cette couche 12 joue le rôle de guide optique. Elle est de préférence réalisée en GaₓIn₁₋ₓAs_{y}P_{1-y}, avec x et y compris entre 0 et 1, et la composition de ce composé quaternaire est adaptée de manière à ce que la largeur de la bande interdite soit égale, en longueur d'onde, à 1,3 *µ*m. De manière avantageuse, cette couche guidante 12 est déposée sur une épaisseur relativement importante, c'est-à-dire sur une épaisseur inférieure à 1*µ*m. Dans l'exemple de la figure 2, cette épaisseur est égale à 0,65 *µ*m. Par conséquent, la couche guidante 12 ainsi réalisée présente un très fort facteur de confinement et de très faibles pertes optiques.

Une couche intermédiaire 13 est alors déposée sur cette première couche de manière à la séparer d'une deuxième couche possédant une fonction optique différente. Cette couche intermédiaire est nécessaire puisqu'elle permet l'obtention de jonctions latérales P-N bloquantes décrites dans ce qui suit. Elle est extrêmement fine et très fortement dopée en porteurs de type n. En effet, comme il a été décrit précédemment, l'épaisseur et le dopage jouent un rôle très important sur la qualité des jonctions bloquantes, mais aussi sur les pertes optiques et sur la qualité du couplage entre deux fonctions optiques différentes. Dans l'exemple de la figure 2C, cette couche possède de préférence une épaisseur de 0,05 *µ*m et un dopage égal à 2.10¹⁸ cm⁻³ en porteurs de type n.

Enfin, une deuxième couche, dite couche active 14, d'un composé quaternaire non dopé, est déposée sur la couche intermédiaire 13 et est recouverte d'une fine couche 15 dopée p. Ceci est représenté sur la figure 2D. La deuxième couche 14 joue le rôle d'amplificateur optique. Elle est de préférence réalisée en GaₓIn₁₋ₓAs_{y}P_{1-y}, avec x et y compris entre 0 et 1, et la composition de ce composé quaternaire est avantageusement adaptée pour que la largeur de la bande interdite soit environ égale à 1.6*µ*m et pour que l'amplificateur émette à une longueur d'onde d'utilisation λg égale à 1,55 *µ*m par exemple. De plus, la somme des épaisseurs des couches 15 et amplificatrice 14 est de préférence inférieure à 0.6*µ*m.

La couche 15 dopée p est avantageusement réalisée en Phosphure d'Indium et possède une épaisseur très fine telle que 0,025 µm par exemple. Cette couche 15 d'InP dopé p permet notamment de faciliter la reprise d'épitaxie lors du dépôt de la couche de gaine 16 permettant d'enterrer le ou les ruban(s) de couche active 14.

Les deux couches 12 et 14, possédant des fonctions optiques différentes, sont par conséquent empilées, de part et d'autre de la couche intermédiaire 13, en une seule étape. Une deuxième étape consiste ensuite à reprendre 1' épitaxie en phase vapeur pour enterrer la couche active 14.

Cependant, avant d'effectuer une reprise d'épitaxie, la couche active 14, et elle seule, est gravée sous la forme d'un ou de plusieurs rubans. Dans l'exemple de la figure 2E un seul ruban de couche active 14 est gravé. Pour cela, un masque 25 est placé sur la couche active. Ce masque possède une largeur définissant la largeur du ruban de couche active à graver. La gravure est ensuite effectuée par un procédé de gravure sèche quelconque.

La gravure est de plus contrôlée in situ au moyen d'un interferomètre qui permet ainsi d'obtenir des profondeurs de gravure très précises et une très bonne reproductibilité. Le procédé de gravure sèche est ensuite suivi d'une légère gravure chimique en milieu humide permettant de régénérer le matériau en surface.

La profondeur de la gravure est de préférence inférieure à 0.6 *µ*m. Cette profondeur permet cependant de graver à la fois la couche de protection 15 d'InP dopée p, la couche active 14, et éventuellement une partie de la couche intermédiaire 13 d'InP dopé n. Le dispositif obtenu à la suite de cette gravure est schématisé sur la figure 2E.

De plus, le (ou les) ruban(s) de couche active 14 ainsi gravé(s) est (sont) avantageusement orienté(s) selon la direction cristallographique [011], qui permet d'obtenir les meilleures performances pour les structures actives enterrées.

Le masque 25 est alors enlevé. Une seconde épitaxie en phase vapeur est ensuite réalisée afin d'enterrer le ruban de couche active 14 de GaInAsP dans une couche de gaine 16 tel qu'illustré sur la figure 2F. La reprise d'épitaxie est réalisée à la fois sur la couche intermédiaire d'InP 13 et sur la couche de protection d'InP 15 restante sur le ruban de couche active.

La reprise d'épitaxie est par conséquent facilement réalisée puisque ces deux couches sont en matériau binaire. La couche de gaine 16 est également réalisée en Phosphure d'Indium (InP), dopé en porteurs de type p, afin de conserver la même structure cristalline que les couches d'InP 13 et 15. L'épaisseur de la couche de gaine est par exemple de 1,8 *µ*m et la concentration en porteurs de type p est importante puisqu'elle est de préférence comprise entre. 2.10¹⁷ et 2.1018 cm⁻³. Dans l'exemple de la figure 2, le dopage en porteurs de type p est égal à 2.1018 cm⁻³. La couche de gaine est alors recouverte par une couche conductrice 18 de GaInAs dopée en porteurs de type p.

A ce stade de la fabrication, un masque 26 photorésistant est placé sur la couche conductrice 18 et dans une région située au-dessus du ruban de couche active 14. Le masque mesure entre 4 et 7 *µ*m de large, de préférence 6 *µ*m. Une implantation, en profondeur, de protons est alors effectuée, de part et d'autre du masque 26, dans les couches conductrice 18, de gaine 16 et la couche intermédiaire 13, de manière à dépasser les jonctions latérales P-N bloquantes. L'implantation de protons permet en effet de détruire partiellement la structure cristalline des couches conductrice 18 d'InGaAs, de gaine 16 d'InP et intermédiaire 13 d'InP, pour augmenter leur résistivité. Du fait de cette implantation de protons, deux régions 17A et 17B de haute résistivité sont alors créés dans les couches conductrice 18, de gaine 16 et intermédiaire 13. Ces deux régions sont situées de part et d'autre d'un canal C d'InP et d'InGaAs, dopé en porteurs de type p, et d'InP, dopé en porteurs de type n, non implanté en protons. C'est par ce canal C que le courant I peut circuler. Le fait d'implanter des protons permet par conséquent de réduire la section du canal C dans lequel circule le courant I et d'augmenter ainsi le confinement du courant dans le ruban de couche active 14.

Enfin, dans une dernière étape du procédé, le masque 26 est retiré et des zones de contacts de Pt/Ti/Au 20 sont déposées sur la couche 18 d'InGaAs tel que schématisé sur la figure 2G.

La couche intermédiaire 13 extrêmement fine et fortement dopée en porteurs de type n, permet d'obtenir des jonctions latérales bloquantes 21 P-N InP/InP, représentées en pointillés sur les figures 2F et 2G, formées à l'interface entre la reprise d'épitaxie p-InP de la couche de gaine 16 et la couche intermédiaire 13 ou alors sous cette interface.

Le dispositif laser enterré à double hétérostructure réalisé selon la présente invention présente une structure similaire au dispositif classique de laser à ruban enterré appelé, en dénomination anglo-saxonne, "Burried Ridge Stripe" (BRS). En effet, le confinement du courant dans la partie active est réalisé par une différence de potentiels auto-construits entre les diodes, ou jonctions, centrale P-I-N et latérales P-N. La différence avec le dispositif BRS classique réside dans le fait que les jonctions latérales P-N sont formées à l'interface entre la reprise d'épitaxie et la très fine couche intermédiaire 13 d'InP dopé n, et non à l'interface entre la reprise d'épitaxie et la couche tampon il d'InP dopé n. Cependant, le type de dispositif BRS classique ne comporte pas de couche guidante ni de couche intermédiaire. Les caractéristiques de ces deux dispositifs ont donc été comparées.

Dans le dispositif laser BRS classique à homostructure InP/InP, le confinement du courant dans la couche active est produit par une large différence de potentiels auto-construits entre les homojonctions latérales P-N InP/couche tampon InP et l'hétérojonction centrale P-I-N InP/GaInAsP/ couche tampon InP.

L'évolution de la densité de courant dans ces deux types de jonction a par conséquent été étudiée en fonction de la tension- appliquée aux bornes du dispositif. Il existe une tension limite de fonctionnement pour laquelle la fuite de densité de courant atteint la densité de courant injecté dans le ruban actif si bien que le confinement du courant disparaît très rapidement.

Cette évolution de la densité de courant dans deux types de jonction a également été étudiée dans le dispositif laser DBH selon l'invention, en fonction de la tension appliquée à ses bornes. Le dispositif laser à hétérostructure InP/Quaternaire selon l'invention comporte en effet des jonctions latérales bloquantes P-N InP/couche intermédiaire InP et des jonctions passantes P-I-N InP/GaInAsP/couche intermédiaire InP.

Lorsque la couche intermédiaire 13 d'InP n'est pas dopée, les potentiels auto-construits sont pratiquement identiques dans les deux types de jonction si bien que le confinement du courant est pratiquement inexistant.

En revanche, l'évolution de la densité de courant dans les deux types de jonctions a été étudiée également en fonction de l'épaisseur et du dopage de la couche intermédiaire. Il a été constaté que les résultats étaient similaires soit en utilisant une épaisseur égale à 0,05 µm et un dopage n supérieur à 2.10¹⁷ · cm⁻³ ou une épaisseur supérieure à 0,01 µm et un dopage égal à 2.10¹⁸ cm ⁻³. De plus, bien que, dans le dispositif à hétérostructure selon l'invention, la nature des jonctions, ou diodes, bloquantes soit différente de celle des jonctions du dispositif BRS classique à homostructure, le confinement du courant et les échelles de tension de fonctionnement sont similaires aux caractéristiques obtenues dans le dispositif BRS classique. Le dispositif réalisé selon la présente invention permet par conséquent d'obtenir de très bonnes performances de diode laser. Il est de plus adaptable aux circuits optiques intégrés complexes et il est réalisé selon un procédé très simple de fabrication utilisant une seule reprise d'épitaxie.

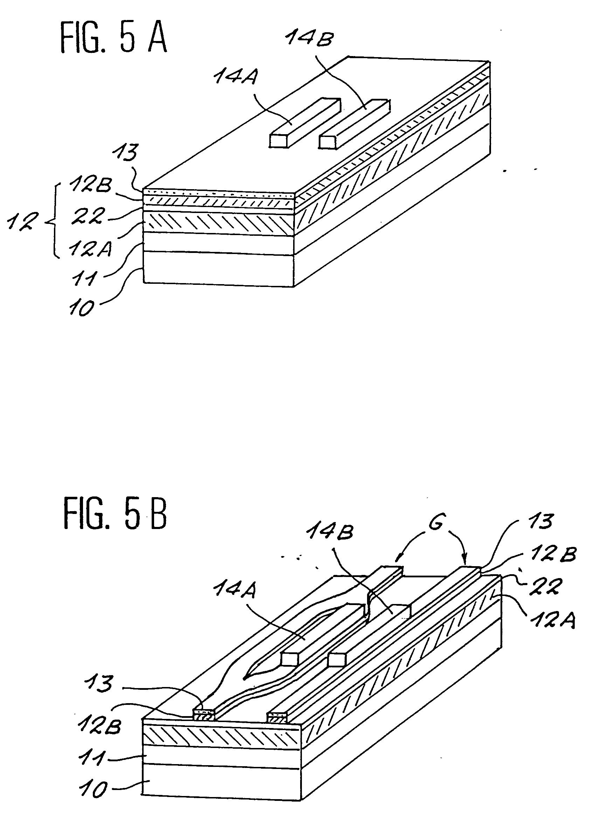

La figure 3 illustre un autre mode de réalisation d'un dispositif selon l'invention à partir duquel il est possible de fabriquer un circuit photonique intégré. Ce dispositif possède une structure similaire à celui de la figure 1. La structure comporte en effet un empilement de couches comprenant : une couche guidante 12 formée d'un composé quaternaire non dopé tel que GaInAsP, une couche intermédiaire 13 d'InP extrêmement fine et fortement dopée en porteurs de type n, une couche active 14 formée d'un composé quaternaire non dopé tel que GaInAsP et gravée sous la forme d'un ou de plusieurs rubans, une couche de gaine 16 d'InP dopé en porteurs de type p, une couche conductrice 18 d'InGaAs et des contacts 20. Les épaisseurs de toutes ces couches sont identiques ou proches de celles du dispositif de la figure 1. De plus, dans cet exemple un seul ruban de couche active est gravé selon une longueur et une largeur déterminées.

Ce mode de réalisation consiste à insérer, dans la couche guidante 12, une deuxième couche intermédiaire 22 extrêmement fine et fortement dopée en porteurs de type n. Ainsi, la couche guidante 12 comprend une première zone guidante 12A formée d'un composé quaternaire non dopé de GaInAsP, une couche intermédiaire 22 extrêmement fine et fortement dopée en porteurs de type n, et une deuxième zone guidante 12B, formée d'un composé quaternaire non dopé de GaInAsP.

De manière avantageuse, la couche intermédiaire 22 est réalisée en matériau binaire tel que de l'InP par exemple et son épaisseur est comprise entre 0.01 et 0.1*µ*m. Dans l'exemple de la figure 3 cettè couche intermédiaire 22 possède une épaisseur de 0.05 *µ*m. De plus la concentration en porteurs de type n, dans cette couche, est comprise entre 2.1017 et 2.1018 cm⁻³.

Cette structure de la couche guidante 12 permet d'assurer la réalisation d'un circuit photonique intégré quelconque. En effet, la couche guidante 12 peut alors être, elle aussi, partiellement gravée afin d'assurer la charge du guide, c'est-à-dire le confinement latéral de la lumière dans le guide. Lors de la gravure du guide, une partie de la deuxième zone guidante 12B est donc enlevée.

Cette gravure est réalisée au moyen d'un procédé de gravure sèche et/ou humide, juste après avoir gravé la couche active 14 sous la forme d'un ou de plusieurs rubans. La couche intermédiaire 22 étant réalisée en matériau binaire d'InP, elle permet de faciliter la reprise d'épitaxie de la couche de gaine 16 d'InP dopé p. L'épaisseur de la deuxième zone guidante 12B est inférieure à celle de la première zone guidante 12A et correspond à la profondeur de la gravure du guide. Dans l'exemple de la figure 3 l'épaisseur de la première zone 12A est égale à 0.5 *µ*m, celle de la couche intermédiaire 22 est égale à 0.05 *µ*m, alors que celle de la deuxième zone guidante 12B est égale à 0.1 *µ*m. Dans ce cas, la profondeur de la gravure est donc de 0.1 *µ*m.

Le couplage entre les deux fonctions optiques est évanescent et vertical. Selon une variante de réalisation, représentée sur la figure 4, ce couplage peut en outre être assisté par une transition adiabatique, c'est-à-dire au moyen d'un adaptateur de modes, entre les deux fonctions optiques. Dans le cas de la structure selon l'invention, cet adaptateur de modes peut être réalisé simplement, de manière avantageuse, en gravant les extrémités du (ou des) ruban(s) de couche active en forme de pointes.

Un exemple de réalisation d'un procédé de fabrication d'un circuit photonique à partir d'un tel dispositif est illustré sur les figures 5A à 5D.

Dans un premier temps les couches guidante 12, active 14 et intermédiaires 13 et 22, sont réalisées par épitaxies en une seule étape, sur la couche tampon 11 d'InP dopé n, elle-même déposée sur le substrat 10 d'InP dopé n, de la même manière que dans l'exemple précédent représenté sur les figures 2A à 2G. De plus, la couche active 14 est gravée sous la forme de rubans 14A et 14B ayant une longueur et une largeur déterminées. Ceci est représenté sur la figure 5A. La gravure de la couche active est effectuée au moyen d'un procédé de gravure sèche et/ou humide, de la même manière que dans l'exemple précédent représenté sur les figures 2A à 2G.

Dans un deuxième temps, tel qu'illustré sur la figure 5B, la couche guidante 12B est gravée afin de créer la charge des guides G, c'est-à-dire le confinement latéral de la lumière dans le guide. La gravure de cette couche est également réalisée au moyen d'un procédé de gravure sèche et/ou humide. Pour réaliser cette gravure, des masques de largeur supérieure à celle des rubans 14A et 14B sont placés et centrés au-dessus de chacun de ces rubans amplificateurs. Les masques possèdent une grande longueur, de manière à recouvrir toute la longueur du dispositif, et une forme appropriée au circuit photonique que l'on souhaite réaliser, pour que les guides G dessinent par exemple des branchements en Y ou des virages. La deuxième couche guidante 12B du guide est ensuite enlevée de part et d'autre de ces masques.

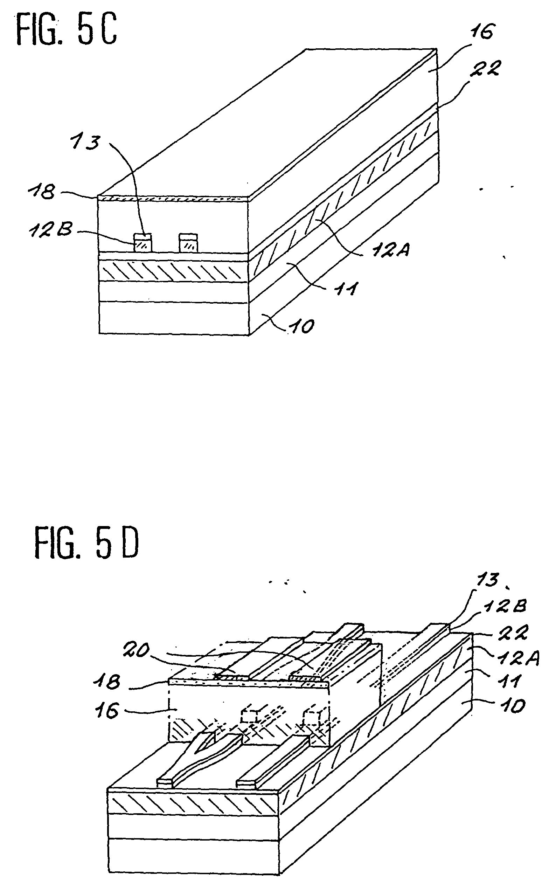

Les masques sont alors retirés et une reprise d'épitaxie est effectuée afin d'enterrer les rubans amplificateurs 14A et 14B et les guides G dans une couche de gaine 16 d'InP dopé p, tel que représenté sur la figure 5C. Le dispositif obtenu à cette étape correspond au dispositif précédemment décrit, illustré par la figure 3, qui ne possède qu'un seul ruban de couche active.

Une étape suivante de ce procédé consiste alors à déterrer uniquement les parties guides G de la couche de gaine 16, et à laisser les rubans amplificateurs 14A, 14B enterrés dans cette couche de gaine. Le déterrement est réalisé également au moyen d'un masque placé au-dessus de la zone où se trouvent les rubans actifs 14A et 14B. Le fait de déterrer les parties guides permet ainsi d'éviter d'avoir de fortes pertes optiques, lors du fonctionnement du circuit photonique intégré, dues à l'absorption des porteurs libres de type p de la couche de gaine 16 par les guides. Les guides G ainsi réalisés sont de type simple hétérostructure.

Dans une variante de réalisation, il est toutefois possible de réaliser des guides de type double hétérostructure et à faibles pertes. Cette variante consiste à retirer la reprise d'épitaxie dopée p dans la partie passive du circuit photonique fabriqué et à réaliser une seconde épitaxie non dopée. Cependant ce type de guide complique sensiblement le procédé de fabrication du dispositif selon l'invention.

Une dernière étape consiste à réaliser des métallisations 20, de type Pt/Ti/Au, au dessus de chaque ruban actif 14A, 14B afin de créer des contacts. Ces métallisations sont réalisées au moyen de procédés bien connus de l'homme de l'art. Le circuit photonique finalement obtenu est représenté sur la figure 5D.

Le procédé de fabrication d'un circuit photonique intégré qui vient d'être décrit est bien-sûr un exemple : il peut en effet être étendu à d'autres types d'intégration, tels que l'intégration d'une photodiode, ou d'un modulateur, ou des intégrations plus complexes comprenant plus de deux fonctions optiques différentes par exemple. Ces différentes fonctions optiques sont soit réalisées dans la même couche : un amplificateur et une photodiode sont par exemple réalisés dans la couche active 14 ; soit séparées l'une de l'autre par une fine couche 13, 22 d'InP fortement dopé en porteurs de type n telle que décrite précédemment. En particulier, la composition de la zone 12B, séparée de la zone 12A par la fine couche intermédiaire 22 d'InP fortement dopé n, peut être différente de celle de la zone 12A.

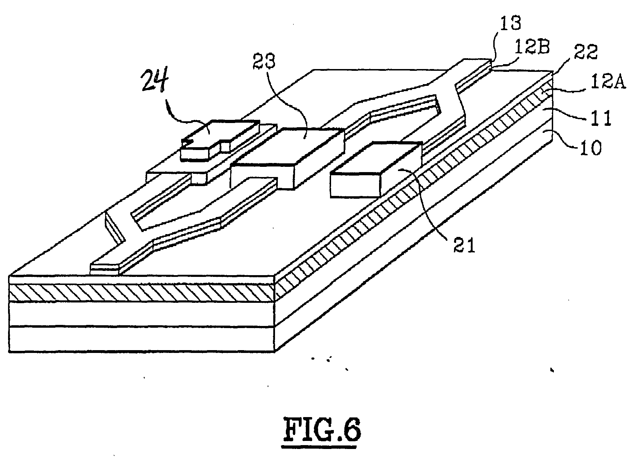

Un exemple d'un dispositif photonique intégré particulier, réalisé selon le procédé de fabrication décrit précédemment, est schématisé sur la figure 6. Ce dispositif est très intéressant pour effectuer de la commutation optique. Il représente plus particulièrement un point d'accès, encore dénommé point de commutation.

Tout comme les dispositifs précédemment décrits, ce point d'accès comprend un substrat 10, une couche tampon 11, une couche guidante 12, une couche intermédiaire 13 et une couche active. La couche active est gravée sous forme de rubans, lesquels sont enterrés dans des couches de gaine. La couche guidante 12 comporte de préférence une première zone guidante 12A, une autre couche intermédiaire 22 et une deuxième couche guidante 12B. La deuxième couche guidante 12B est par ailleurs gravée de manière à assurer la charge du guide et à former deux branchements en Y placés en quinconce. Ce point d'accès possède trois fonctions optiques différentes, lesquelles sont réalisées dans la même couche. Ces fonctions optiques, réalisées dans la couche active, sont assurées respectivement par une photodiode 22, un laser 21 et un amplificateur 23.

Plusieurs points d'accès semblables à celui-ci peuvent ainsi être placés en des points quelconques d'un réseau. La photodiode 24 joue alors le rôle de récepteur et permet par conséquent d'extraire, en un point quelconque d'un réseau, un signal optique. L'amplificateur 23, quant à lui, joue le rôle de porte optique et permet de compenser les pertes optiques, c'est-à-dire de régénérer le signal optique issu du réseau. Enfin, le laser 21, joue le rôle d'émetteur et permet de réinjecter un signal optique dans le réseau.

## Revendications

1. Dispositif laser, ou amplificateur à guide optique, enterré à double hétérostructure caractérisé en ce qu'il comprend :
- une couche tampon (11) dopée en porteurs d'un premier type et recouvrant toute la surface (100) d'un substrat (10) dopé en porteurs du même type,
- une première couche guidante (12 ; 12A), jouant le rôle de guide optique, formée d'un composé quaternaire non dopé et recouvrant toute la surface de la couche tampon (11),
- une couche intermédiaire (13) d'une épaisseur comprise entre 0,01 µm et 0.1 µm, dopée en porteurs du premier type à une concentration comprise entre 2.10 et 2.10¹⁸ cm⁻³, et recouvrant au moins une partie de la surface de la couche guidante (12 ; 12A),
- un ou plusieurs ruban(s) (14, 14A, 14B) de couche active (14), jouant le rôle de laser (s) ou d'amplificateur(s) formé(s) d'un composé quaternaire non dopé, et
- une couche de gaine (16) dopée en porteurs d'un deuxième type.

2. Dispositif selon la revendication 1, caractérisé en ce que l'épaisseur de la première couche guidante (12 ; 12A) est inférieure à 1 µm et supérieure à 0,3 µm.

3. Dispositif selon l'une des revendications 1 à 2,
caractérisé en ce qu'il comprend en outre :
- une deuxième couche intermédiaire (22) d'une épaisseur comprise entre 0,01 µm et 0.1 µm, dopée en porteurs du premier type à une concentration comprise entre 2.10¹⁷ et 2.10¹⁸ cm⁻³, et recouvrant toute la surface de la première couche guidante (12A), et
- un ruban d'une deuxième couche guidante (12B), apte à assurer la charge de la première couche guidante (12A), formé d'un composé quaternaire non dopé, situé sur la deuxième couche intermédiaire (22) et recouvert par la première couche intermédiaire (13), la première couche intermédiaire (13) étant également en forme d'un ruban.

4. Dispositif selon l'une des revendications 1 à 3,
caractérisé en ce que la (les) couche(s) intermédiaire(s) (13, 22) comprend(nent) du Phosphure d'Indium.

5. Dispositif selon l'une des revendications 1 à 4,
caractérisé en ce que l'épaisseur de la couche active (14) est inférieure 0.6 µm.

6. Dispositif selon l'une des revendications 1 à 5,
caractérisé en ce que le composé quaternaire formant la (les) couches) guidante(s) (12; 12A, 12B) et la couche active (14) est du GaInAsP.

7. Dispositif selon l'une des revendications 1 à 6,
caractérisé en ce que le ou les ruban(s) gravé(s) dans la couche active (14) est (sont) orienté(s) selon la direction cristallographique [011].

8. Dispositif selon l'une des revendications 1 à 7,
caractérisé en ce qu'il comprend en outre un adaptateur de modes en pointes, réalisé entre les deux fonctions optiques guide et amplificateur.

9. Dispositif selon l'une des revendications 1 à 8, caractérisé en ce qu'il comprend une photodiode (24) jouant le rôle de récepteur, un laser (21) jouant le rôle d'émetteur et un amplificateur (23) jouant le rôle de porte optique, de manière à former un point d'accès.

10. Procédé de fabrication d'un dispositif à structure enterrée, selon l'une quelconque des revendications précédentes, et d'intégration de ce dernier dans un circuit photonique, caractérisé en ce qu'il consiste à faire croître successivement, sur une couche tampon (11) dopée en porteurs d'un premier type, elle-même déposée sur toute une surface (100) d'un substrat (10) dopé en porteurs du même type, une première couche guidante (12 ; 12A) formée par un composé quaternaire non dopé, une couche intermédiaire (13) d'une épaisseur comprise entre 0,01 µm et 0.1 µm et fortement dopée en porteurs du premier type à une concentration comprise entre 2.10¹⁷ et 2.10¹⁸ cm⁻³, une deuxième couche (14) dite couche active formée d'un composé quaternaire non dopé, et une couche de protection (15) dopée en porteurs d'un deuxième type; et en ce que la couche active (14) est gravée sous la forme d'un ou de plusieurs rubans (14, 14A, 14B), puis enterrée dans une couche de gaine (16) dopée en porteurs du deuxième type.

11. Procédé selon la revendication 10, caractérisé en ce que la croissance de la première couche guidante (12 ; 12A) est réalisée sur une épaisseur inférieure à 1 µm et supérieure à 0,3 µm.

12. Procédé selon l'une des revendications 10 à 11,
caractérisé en ce qu'il consiste en outre à faire croître successivement sur la première couche guidante (12A), une deuxième couche intermédiaire (22) d'une épaisseur comprise entre 0,01 et 0.1 µm et dopée en porteurs du premier type à une concentration comprise entre 2.10¹⁷ et 2.10¹⁸ cm⁻³, et une deuxième couche guidante (12B) formée d'un composé quaternaire non dopé; et en ce que la première couche intermédiaire (13) et la deuxième couche guidante (12B) sont gravées sous la forme d'un ruban situé sous le(s) ruban (s) (14, 14A, 14B) de couche active, afin d'assurer la charge de la première couche guidante (12A).

13. Procédé selon l'une des revendications 10 à 12, caractérisé en ce que la (les) couche(s) intermédiaire(s) (13, 22) est (sont) réalisée(s) en Phosphure d'Indium.

14. Procédé selon l'une des revendications 10 à 13, caractérisé en ce que la croissance de la couche active (14) est réalisée sur une épaisseur inférieure à 0.6 µm.

15. Procédé selon l'une des revendications 10 à 14, caractérisé en ce que la (les) couche(s) guidante(s) (12; 12A, 12B) et la couche active (14) sont réalisées en matériau quaternaire de GaInAsP.

16. Procédé selon l'une des revendications 10 à 15,
caractérisé en ce que la croissance des couches guidantes (12; 12A, 12B), intermédiaire(s) (13, 22) et active (14) est réalisée en une seule étape, par épitaxie en phase vapeur.

17. Procédé selon l'une des revendications 10 à 16 caractérisé en ce que la gravure de la couche active (14), ou de la couche active (14) et de la deuxième couche guidante (12B), est effectuée par un procédé de gravure sèche et/ou humide, et en ce que le ou les ruban(s) (14, 14A, 14B) de couche active gravée est (sont) orienté(s) selon la direction cristallographique [011].

18. Procédé selon l'une des revendications 10 à 17, caractérisé en ce qu'une reprise d' épitaxie permet de faire croître la couche de gaine (16), réalisée en Phosphure d'Indium, de manière à enterrer le ruban de la couche active (14), ou les rubans de couche active (14) et de deuxième couche guidante (12B).

19. Procédé selon l'une des revendications 10 à 18, caractérisé en ce qu'au moins la couche de gaine (16), une couche conductrice (18) d'InGaAs, recouvrant cette couche de gaine, et la couche intermédiaire (13) sont implantées en profondeur en protons, dans deux régions (17A, 17B) situées de part et d'autre d'un canal (C) dans lequel circule le courant de fonctionnement.

20. Procédé selon l'une des revendications 10 à 19,
caractérisé en ce qu'un adaptateur de modes en pointes est réalisé entre deux fonctions optiques guide et amplificateur.

## Patentansprüche

1. Laser- oder Lichtleiterverstärker-Vorrichtung mit vergrabener Doppel-Heterostruktur,
**dadurch gekennzeichnet**, dass sie umfasst:
- eine Pufferschicht (11), mit Trägern eines ersten Typs dotiert und die gesamte Oberfläche (100) eines mit Trägern desselben Typs dotierten Substrats (10) bedeckend,
- eine erste Leiterschicht (12; 12A), die Rolle des Lichtleiters spielend, aus einer nicht-dotierten quarternären Verbindung gebildet und die gesamte Oberfläche der Pufferschicht (11) bedeckend,
- eine Zwischenschicht (13) mit einer zwischen 0,01 µm und 0,1 µm enthaltenen Dicke, dotiert mit Trägern des ersten Typs mit einer zwischen 2.10¹⁷ und 2.10¹⁸ cm⁻³ enthaltenen Konzentration und wenigstens einen Teil der Oberfläche der Leiterschicht (12; 12A) bedeckend,
- einen oder mehrere Streifen (14, 14A, 14B) einer aktiven Schicht (14), die die Rolle der (des) Laser(s)- oder Verstärker(s) spielt, gebildet aus einer nicht-dotierten quarternären Verbindung, und
- eine Umhüllungsschicht (16), dotiert mit Trägern eines zweiten Typs.

2. Vorrichtung nach Anspruch 1, dadurch gekennzeichnet, dass die Dicke der ersten Leiterschicht (12; 12A) kleiner als 1 um und größer als 0,3 µm ist.

3. Vorrichtung nach einem der Ansprüche 1 und 2, dadurch gekennzeichnet, dass sie außerdem umfasst:
- eine zweite Zwischenschicht (22) mit einer zwischen 0,01 µm und 0,1 µm enthaltenen Dicke, dotiert mit Trägern des ersten Typs mit einer zwischen 2.10¹⁷ und 2.10¹⁸ cm⁻³ enthaltenen Konzentration, die die gesamte Oberfläche der ersten Leiterschicht (12A) bedeckt, und
- einen Streifen einer zweiten Leiterschicht (12B), fähig die Ladung der ersten Leiterschicht (12A) zu gewährleisten, gebildet aus einer nicht-dotierten quarternären Verbindung und bedeckt durch die erste Zwischenschicht (13), wobei die erste Zwischenschicht (13) ebenfalls die Form eines Streifens aufweist.

4. Vorrichtung nach einem der Ansprüche 1 bis 3, dadurch gekennzeichnet, dass die Zwischenschicht(en) (13, 22) Indiumphosphid enthalten.

5. Vorrichtung nach einem der Ansprüche 1 bis 4, dadurch gekennzeichnet, dass die Dicke der aktiven Schicht (14) kleiner als 0,6 µm ist.

6. Vorrichtung nach einem der Ansprüche 1 bis 5, dadurch gekennzeichnet, dass die die Leiterschicht(en) (12; 12A, 12B) und die aktive Schicht (14) bildende quarternäre Verbindung GalnAsP ist.

7. Vorrichtung nach einem der Ansprüche 1 bis 6, dadurch gekennzeichnet, dass der (die) aus der aktiven Schicht (14) geätzte(n) Streifen der kristallographischen Richtung [011] entsprechend ausgerichtet ist (sind).

8. Vorrichtung nach einem der Ansprüche 1 bis 7, dadurch gekennzeichnet, dass sie außerdem einen Spitzenmodenadapter (adapteur des modes en pointes) umfasst, realisiert zwischen den beiden optischen Funktionen Leiter und Verstärker.

9. Vorrichtung nach einem der Ansprüche 1 bis 8, dadurch gekennzeichnet, dass sie eine die Rolle des Empfängers spielende Photodiode (24), einen die Rolle des Senders spielenden Laser (21) und einen die Rolle des optischen Tors bzw. Glieds spielenden Verstärker (23) umfasst, um einen Zugriffspunkt zu bilden.

10. Verfahren zur Herstellung einer Vorrichtung mit vergrabener Struktur nach einem der vorangehenden Ansprüche und zur Integration dieser Struktur in eine photonische Schaltung, gekennzeichnet durch das sukzessive Abscheiden einer mit Trägern eines ersten Typs dotierten Pufferschicht (11), ihrerseits selbst auf einer ganzen Oberfläche (100) eines mit Trägern desselben Typs dotierten Substrats (10) abgeschieden, einer ersten Leiterschicht (12; 12A), gebildet durch eine nicht-dotierte quartäre Verbindung, einer. Zwischenschicht (13) mit einer zwischen 0,1 µm und 0,1 µm enthaltenen Dicke und stark mit Trägern des ersten Typs mit einer zwischen 2.10¹⁷ und 2.10¹⁸ cm⁻³ enthaltenen Konzentration dotiert, einer zweiten Schicht (14), aktive Schicht genannt, gebildet aus einer nicht-dotierten quartemären Verbindung, und einer Schutzschicht (15), dotiert mit Trägern eines zweiten Typs; und dadurch, dass die aktive Schicht (14) in Form eines oder mehrerer Streifen (14, 14A, 14B) geätzt und dann in einer mit Trägern des zweiten Typs dotierten Umhüllungsschicht (16) vergraben wird.

11. Verfahren nach Anspruch 10, dadurch gekennzeichnet, dass das Aufwachsen der ersten Leiterschicht (12; 12A) über eine Dicke erfolgt, die kleiner als 1 µm und größer als 0,3 um ist.

12. Verfahren nach einem der Ansprüche 10 bis 11, dadurch gekennzeichnet, dass man außerdem auf der ersten Leiterschicht (12A) eine zweite Zwischenschicht (22) mit einer zwischen 0,01 und 0,1 µm enthaltenen Dicke und mit Trägern des ersten Typs mit einer zwischen 2.10¹⁷ und 2.10¹⁸ cm⁻³ enthaltenen Konzentration und eine aus einer nicht-dotierten quartären Verbindung gebildete zweite Leiterschicht (12B) aufwachsen lässt, und dadurch, dass man der ersten Zwischenschicht (13) und der zweiten Leiterschicht (12B) durch Ätzen die Form eines Streifens verleiht, der sich unter dem (den) Streifen (14, 14A, 14B) der aktiven Schicht befindet, um die Ladung der ersten Leiterschicht (12A) sicherzustellen.

13. Verfahren nach einem der Ansprüche 10 bis 12, dadurch gekennzeichnet, dass die Zwischenschicht(en) (13, 22) aus Indiumphosphid realisiert wird (werden).

14. Verfahren nach einem der Ansprüche 10 bis 13, dadurch gekennzeichnet, dass das Aufwachsen der aktiven Schicht über eine Dicke von unter 0,6 µm erfolgt.

15. Verfahren nach einem der Ansprüche 10 bis 14, dadurch gekennzeichnet, dass die Leiterschicht(en) (12; 12A, 12B) und die aktive Schicht (14) aus quarternärem GalnAsP-Material realisiert wird (werden).

16. Verfahren nach einem der Ansprüche 10 bis 15, dadurch gekennzeichnet, dass das Aufwachsen der Leiterschichten (12; 12A, 12B), der Zwischenschicht(en) (13, 22) und der aktiven Schicht (14) in einem einzigen Schritt erfolgt, durch Gasphasen-Epitaxie.

17. Verfahren nach einem der Ansprüche 10 bis 16, dadurch gekennzeichnet, dass das Ätzen der aktiven Schicht (14) oder der aktiven Schicht (14) und der zweiten Leiterschicht (12B) durch ein trockenes und/oder nasses Ätzverfahren erfolgt, und dadurch, dass der oder die Streifen (14, 14A, 14B) aus der geätzten aktiven Schicht entsprechend der kristallographischen Richtung [001] ausgerichtet ist bzw. sind.

18. Verfahren nach einem der Ansprüche 10 bis 17, dadurch gekennzeichnet, dass eine Wiederaufnahme bzw. Fortsetzung der Epitaxie ermöglicht, die aus Indiumphosphid realisierte Umhüllungsschicht (16) aufwachsen zu lassen, um den Streifen aus der aktiven Schicht (14) oder die Streifen aus der aktiven Schicht (14) und der zweiten Leiterschicht (12B) zu vergraben.

19. Verfahren nach einem der Ansprüche 10 bis 18, dadurch gekennzeichnet, dass wenigstens die Umhüllungsschicht (16), eine diese Umhüllungsschicht bedeckende Leiterschicht (18) aus InGaAs und die Zwischenschicht (13) in der Tiefe mit Protonen implantiert werden, in zwei Bereichen (17A, 17B), beiderseits eines Kanals (C) befindlich, in dem der Betriebsstrom fließt.

20. Verfahren nach einem der Ansprüche 10 bis 19, dadurch gekennzeichnet, dass ein Spitzenmodenadapter (adapteur de modes en pointes) realisiert wird zwischen den beiden optischen Funktionen Leiter und Verstärker.

## Claims

1. Double buried heterostructure laser device, or optical wave guide amplifier, characterised in that it comprises:
- a buffer layer (11) doped with carriers of a first type and covering all the surface (100) of a substrate (10) doped with carriers of the same type,
- a first guiding layer (12; 12A), playing the role of optical wave guide, formed of an undoped quaternary compound and covering all the surface of the buffer layer (11),
- an intermediary layer (13) with a thickness of between 0.01 *µ*m and 0.1 *µ*m, doped with carriers of the first type at a concentration of between 2.10¹⁷ and 2.1018 cm⁻³, and covering at least a portion of the surface of the guiding layer (12; 12A),
- one or more stripes (14, 14A, 14B) of active layer (14), playing the role of laser(s) or amplifier(s) formed of an undoped quaternary compound, and
- a covering layer (16) doped with carriers of a second type.

2. Device according to claim 1, characterised in that the thickness of the first guiding layer (12; 12A) is less than 1 *µ* m and greater than 0.3 *µ*m.

3. Device according to one of claims 1 to 2, characterised in that it additionally comprises:
- a second intermediary layer (22) with a thickness of between 0.01 *µ*m and 0.1 *µ*m, doped with carriers of the first type at a concentration of between 2.10¹⁷ and 2.10¹⁸ cm⁻³, and covering all the surface of the first guiding layer (12A), and
- a stripe of a second guiding layer (12B), suitable for charging the first guiding layer (12A), formed of an undoped quaternary compound, situated on the second intermediary layer (22) and covered by the first intermediary layer (13), the first intermediary layer (13) also being in the form of a stripe.

4. Device according to one of claims 1 to 3, characterised in that the intermediary layer or layers (13, 22) comprise indium phosphorous.

5. Device according to one of claims 1 to 4, characterised in that the thickness of the active layer (14) is less than 0.6 *µ*m.

6. Device according to one of claims 1 to 5, characterised in that the quaternary compound forming the guiding layer or layers (12; 12A, 12B) and the active layer (14) is GaInAsP.

7. Device according to one of claims 1 to 6, characterised in that the stripe or stripes etched in the active layer (14) are oriented in the crystallographic direction [011] .

8. Device according to one of claims 1 to 7, characterised in that it additionally comprises a tapering mode adapter between the two wave guide and amplifier optical functions.

9. Device according to one of claims 1 to 8, characterised in that it comprises a photodiode (24) playing the role of receiver, a laser (21) playing the role of transmitter and an amplifier (23) playing the role of optical gate, so as to form an access point.

10. Process for production of a buried structure device according to any one of the preceding claims, and for integration of the latter in a photon circuit, characterised in that it consists in successively growing a first guiding layer (12; 12A) formed of an undoped quaternary compound, an intermediary layer (13) with a thickness of between 0.01 *µ*m and 0,1 *µ*m and heavily doped with carriers of the first type at a concentration of between 2.10¹⁷ and 2.10¹⁸ cm⁻³, a second so-called active layer (14) formed of an undoped quaternary compound, and a protective layer (15) doped with carriers of a second type, on a buffer layer (11) doped with carriers of a first type, itself deposited on all a surface (100) of a substrate (10) doped with carriers of the same type; and in that the active layer (14) is etched in the form of one or more stripes (14, 14A, 14B), then buried in a covering layer (16) doped with carriers of the second type.

11. Process according to claim 10, characterised in that the first guiding layer (12; 12A) is grown over a thickness of less than 1 *µ*m and greater than 0.3 *µ*m.

12. Process according to one of claims 10 to 11, characterised in that it additionally consists in successively growing a second intermediary layer (22) with a thickness of between 0.01 and 0.1 *µ*m and doped with carriers of the first type at a concentration of between 2.10¹⁷ and 2.10¹⁸ cm⁻³, and a second guiding layer (12B) formed of an undoped quaternary compound, on the first guiding layer (12A); and in that the first intermediary layer (13) and the second guiding layer (12B) are etched in the form of a stripe situated under the stripe or stripes (14, 14A, 14B) of active layer in order to charge the first guiding layer (12A).

13. Process according to one of claims 10 to 12, characterised in that the intermediary layer or layers (13, 22) are formed of indium phosphorous.

14. Process according to one of claims 10 to 13, characterised in that the active layer (14) is grown over a thickness of less than 0.6 *µ*m.

15. Process according to one of claims 10 to 14, characterised in that the guiding layer or layers (12; 12A, 12B) and the active layer (14) are formed of GaInAsP quaternary material.

16. Process according to one of claims 10 to 15, characterised in that the guiding layers (12; 12A, 12B), intermediary layer or layers (13, 22) and active layer (14) are grown in a single step by vapour phase epitaxy.

17. Process according to one of claims 10 to 16, characterised in that the active layer (14), or the active layer (14) and the second guiding layer (12B), are etched by a dry and/or wet etching process, and in that the stripe or stripes (14, 14A, 14B) of etched active layer are oriented in the crystallographic direction [011].

18. Process according to one of claims 10 to 17, characterised in that further epitaxy makes it possible to grow the covering layer (16), formed of indium phosphorous, so as to bury the stripe of the active layer (14), or the stripes of active layer (14) and second guiding layer (12B).

19. Process according to one of claims 10 to 18, characterised in that at least the covering layer (16), a conducting layer (18) of InGaAs, covering that covering layer, and the intermediary layer (13) are formed by proton implantation in two regions (17A, 17B) situated on either side of a channel (C) in which the operating current flows.

20. Process according to one of claims 10 to 19, characterised in that a tapering mode adapter is formed between two wave guide and amplifier optical functions.
